# EUROPÄISCHE PATENTSCHRIFT

(11) **EP 3 583 829 B1**
(45) Veröffentlichungstag und Bekanntmachung des Hinweises auf die Patenterteilung: **13.08.2025**
(21) Anmeldenummer: 18700489.0
(22) Anmeldetag: 15.01.2018
(51) Int. Cl.: H05K 1/18, H05K 3/28, H05K 3/34

(54) **LEITERPLATTE MIT GESTAPELTEN BAUELEMENTEN UND VERFAHREN ZUR DEREN HERSTELLUNG**
PRINTED CIRCUIT BOARD WITH STACKED COMPONENTS AND METHOD FOR THE PRODUCTION THEREOF
CARTE DE CIRCUIT IMPRIMÉ À COMPOSANTS EMPILÉS ET PROCÉDÉ DE FABRICATION DE CELLE-CI

(30) Priorität: 15.02.2017 DE 102017102999
(43) Veröffentlichungstag der Anmeldung: 25.12.2019
(73) Patentinhaber: Endress+Hauser SE+Co. KG, 79689 Maulburg (DE)
(72) Erfinder: BIRGEL, Dietmar, 79650 Schopfheim (DE); BANNWARTH, Alexander, 79739 Schwörstadt (DE); BURGER, Paul, 79650 Schopfheim (DE)
(74) Vertreter: Endress + Hauser Group Services (Deutschland) AG+Co. KG
(86) Internationale Anmeldenummer: PCT/EP2018/050832
(87) Internationale Veröffentlichungsnummer: WO 2018/149575

(56) Entgegenhaltungen:
- EP-A2- 0 727 819
- WO-A1-98/20713
- DE-A1- 102007 010 731
- US-A1- 2016 163 613
- ANONYMOUS: "Conformal plastic sheet coating for protection & holding of components", RESEARCH DISCLOSURE, KENNETH MASON PUBLICATIONS, HAMPSHIRE, UK, GB, vol. 338, no. 84, 1 June 1992 (1992-06-01), XP007117834, ISSN: 0374-4353
- "ROLL FEED COVERLAY PRESS", IBM TECHNICAL DISCLOSURE BULLETIN, INTERNATIONAL BUSINESS MACHINES CORP. (THORNWOOD), US, vol. 37, no. 6A, 1 June 1994 (1994-06-01), pages 489/490, XP000455858, ISSN: 0018-8689

## Beschreibung

Die Erfindung betrifft eine Leiterplatte, wobei auf zumindest einer Oberfläche der Leiterplatte Lötkontakte mit darauf aufgelöteten Bauelementen, Leiterbahnen sowie die Lötkontakte und/oder die Leiterbahnen gegeneinander isolierende Bereiche vorgesehen sind. Auf zumindest einem ersten Anteil der isolierenden Bereiche, vorzugsweise einem Großteil der isolierenden Bereiche, ist eine als Lötstoppschicht dienende erste Folie aufgebracht. Ferner betrifft die Erfindung ein Verfahren zur Herstellung der erfindungsgemäßen Leiterplatte.

Eine Vielzahl der elektronischen Bauelemente ist dabei als oberflächen-montierbare Bauelemente, so genannte 'Surface Mounted Devices' bzw. SMD-Bauelemente erhältlich. SMD-Bauelemente benötigen keine Leiterplatten-löcher zur Montage, sondern werden mit ihren Kontakten direkt an vorgesehenen Anschlüsse aufgelötet. SMD-Bauelemente werden mit Bestückungsautomaten maschinell auf mit Lotpaste versehene Kontaktflächen auf der Leiterplatte platziert und gemeinsam in einem einzigen Reflow-Prozess aufgelötet. Neben den SMD Bauelementen gibt es noch eine Vielzahl von speziellen Bauelementen, die bedingt durch ihre Funktion größere Abmessungen aufweisen. Diese Bauelemente sind bevorzugt als Through Hole Technology- bzw. THT-Bauelemente ausgebildet. THT-Bauelemente weisen stiftförmige Anschlussdrähte auf, die durch metallisierte Anschlussbohrungen oder Durchkontaktierungen in der Leiterplatte hindurch gesteckt werden. THT Bauelemente werden typischerweise in einem Selektiv- oder Wellenlötverfahren verlötet.

Die Lötstoppschicht dient dabei zunächst dem Schutz der Leiterbahnen vor dem flüssigen Lot während dem Löten der Lötkontakte der Bauelemente auf die Oberfläche der Leiterplatte. Im Rahmen dieser Anmeldung werden sowohl die Kontaktflächen der SMD-Bauelemente, als auch die Durchkontaktierungen der THT-Bauelemente als "Lötkontakte" bezeichnet. Die Lötstoppschicht verhindert dabei das Benetzen der mit ihr überzogenen Bereiche der Oberfläche der Leiterplatte. Dadurch wird erreicht, dass das flüssige Lot keine Brücken auf den isolierenden Bereichen ausbilden kann. Die Lötstoppschicht wird im Stand der Technik im Rahmen des Herstellungsprozesses der Leiterplatte auf die unbestückte Leiterplatte aufgebracht.

Im Stand der Technik sind zwei Arten von Leiterplatten mit jeweils einer einheitlichen Lötstoppschicht bekannt. Entweder handelt es sich um eine als Lötstopplack aufgebrachte einheitliche Lötstoppschicht oder um eine als Folie aufgebrachte einheitliche Lötstoppschicht. Da die Lötstoppschicht nur in den der elektrischen Isolation dienenden Bereichen (kurz: isolierenden Bereichen) der Oberfläche der Leiterplatte vorhanden ist, muss sie selektiv aufgebracht werden. Für eine als Lötstopplack ausgebildete Lötstoppschicht wird zunächst vollflächig nicht-ausgehärteter Lötstopplack auf die gesamte Oberfläche der Leiterplatte aufgebracht. Dieser wird anschließend in dem isolierenden Bereich selektiv ausgehärtet, beispielsweise mittels phototechnischer Methoden. Anschließend wird der nicht-ausgehärtete Lötstopplack aus dem nichtisolierenden und damit freizustellenden Bereich (beispielsweise dem Bereich der Lötkontakte) von der Oberfläche der Leiterplatte entfernt. Eine als Folie ausgebildete Lötstoppschicht wird dagegen aufgebracht, indem die Folie, gegebenenfalls mittels eines Fügemittels, auf die Oberfläche der Leiterplatte gepresst wird. Die Folie weist dabei ein Negativ des freizustellenden Bereichs auf der Leiterplatte auf. Durch die anschließende Entfernung des Negativs, beispielsweise durch Ätzen, wird die in den isolierenden Bereichen selektiv aufgebrachte und als Folie ausgebildete Lötstoppschicht erhalten.

Des Weiteren ist aus US 2016/163613 A1 eine verkapselte Anordnung von SMD-Bauelementen mit auf der Verkapselung angeordneten THT-Bauelemente bekannt, um eine platzsparende Anordnung zu erhalten. Das IBM TECHNICAL DISCLOSURE BULLETIN Bd. 37, Nr. 6A, 1. Juni 1994 (1994-06-01), Seite 489/490, ISSN: 0018-8689 offenbart eine Rolle-zu Rolle-Verfahren, um Leiterplatten mit einer isolierenden Folie zu versehen. Weitere Beispiele verkapselter bzw. gestapelter Bauelemente sind aus EP 0 727 819 A2, WO 98/20713 A1 und DE 10 2007 010731 A1 bekannt.

Die Lötstoppschicht bestimmt auch den elektrischen Widerstand des damit beschichteten isolierenden Bereichs, kurz: den Isolationswiderstand. Bei vorgegebener Geometrie der Lötkontakte und/oder Leiterbahnen wird der Isolationswiderstand im Wesentlichen durch die Materialeigenschaften der Lötstoppschicht bestimmt. Die als Folie ausgebildete Lötstoppschicht weist in der Regel eine wesentliche größere Lötstoppschicht-Dicke auf (ca. 80-150 Mikrometer), als die Lötstoppschicht-Dicke der als Lötstopplack aufgebrachten Lötstoppschicht (ca. 5-40 Mikrometer). Aufgrund der größeren Lötstoppschicht-Dicke lassen sich mit der Folie daher oftmals höhere Isolationswiderstände erreichen.

Ein hoher, durch die Lötstoppschicht mitbestimmter Isolationswiderstand ist insbesondere dann erforderlich, wenn die Leiterplatte Teil eines Feldgeräts der Automatisierungstechnik ist, welches in explosionsgefährdeten Bereichen betrieben werden soll. Der Explosionsschutz wird hier dadurch erzielt, dass der Isolationswiderstand oberhalb eines in entsprechenden Normen geforderten Mindestwiderstands liegt. Dadurch ist ein Kurzschluss auch im Fehlerfall ausgeschlossen. HF-Bauelemente erfordern dabei einen besonders hohen Isolationswiderstand zwischen ihren Lötkontakten. HF ist Abkürzung für "Hochfrequenz", wobei als HF-Bauelemente die für Hochfrequenz-Technik verwendeten Komponenten wie beispielsweise Kabel, Stecker, Antennen, Transistoren oder andere Komponenten bezeichnet werden.

Oftmals ist der Platz zur Anordnung der Bauelemente auf einer Leiterplatte stark begrenzt. Dies ist zum Einen dadurch bedingt, dass zum Beispiel aufgrund von vielfältigen Funktionalitäten des Feldgerätes eine Vielzahl von unterschiedlichen Bauelementen auf der Leiterplatte platziert werden soll. Zum anderen wird der verfügbare Platz auf der Oberfläche der Leiterplatte weiter eingeschränkt, falls der Explosionsschutz die oben erwähnten Mindestabstände zwischen Bauelementen, Leiterbahnen und/oder Lötkontakten erforderlich macht.

Der Erfindung liegt daher die Aufgabe zugrunde, eine Leiterplatte mit einer platzsparenden Anordnung der Bauelemente anzugeben. Ferner liegt der Erfindung die Aufgabe zugrunde, ein Verfahren zur Herstellung der erfindungsgemäßen Leiterplatte anzugeben.

Die Aufgabe wird gelöst durch eine Leiterplatte, wobei auf zumindest einer Oberfläche der Leiterplatte Lötkontakte mit darauf aufgelöteten Bauelementen, Leiterbahnen sowie die Lötkontakte und/oder die Leiterbahnen gegeneinander isolierende Bereiche vorgesehen sind. Auf zumindest einem ersten Anteil der isolierenden Bereiche, vorzugsweise einem Großteil der isolierenden Bereiche, ist eine als Lötstoppschicht dienende erste Folie aufgebracht. Zumindest eines der Bauelemente ist in einer zu der Oberfläche der Leiterplatte im Wesentlichen senkrechten Richtung zwischen der Leiterplatte und der ersten Folie angeordnet und zumindest teilweise, insbesondere vollständig, durch die erste Folie abgedeckt.

Die erfindungsgemäße Leiterplatte nutzt vorteilhaft die als Lötstoppschicht dienende Folie gleichzeitig zur Abdeckung zumindest eines Bauelements, wodurch eine platzsparende Anordnung der Bauelemente unter gleichzeitiger Einhaltung des erforderlichen, durch die erste Folie mitbestimmten, Isolationswiderstands erreicht wird. Für den Fall, dass das Bauelement z.B. vollständig durch die erste Folie abgedeckt ist, wird von dem abgedeckten Bauelement dadurch im Wesentlichen kein Platz auf der Oberfläche der Leiterplatte beansprucht.

Erfindungsgemäß weist die Leiterplatte unbedeckte, insbesondere THT- oder SMDaufgelötete Bauelemente auf, an deren Lötkontakte jeweils die als Lötstoppschicht dienende erste Folie angrenzt. Die Folie dient in dieser Ausgestaltung als Lötstoppschicht, die an die Lötkontakte angrenzt, z.B. indem sie zwischen den Lötkontakten der THT- oder SMD-aufgelöteten Bauelemente angeordnet ist.

In einer weiteren Ausgestaltung ist das durch die erste Folie abgedeckte Bauelement oder zumindest eines der durch die erste Folie abgedeckten Bauelemente in einer in der Leiterplatte eingebrachten Kavität angeordnet.

Bevorzugt ist die Kavität derart bemessen, dass das durch die erste Folie abgedeckte Bauelement im Wesentlichen vollständig innerhalb der Kavität angeordnet ist. Dadurch liegt die Folie im Wesentlichen vollkommen eben auf der Leiterplatte und dem abgedeckten Bauelement auf.

In einer Weiterbildung ist auf einem zweiten Anteil der isolierenden Bereiche ein als Lötstoppschicht dienender Lötstopplack aufgebracht. Alternativ oder zusätzlich ist auf einem drittem Anteil der isolierenden Bereiche eine als Lötstoppschicht dienende zweite Folie aufgebracht. Der Lötstopplack und/oder die zweite Folie weisen eine Lötstoppschicht-Dicke auf, die von der Lötstoppschicht-Dicke der das zumindest eine Bauelement abdeckenden ersten Folie verschieden ist. In dieser Weiterbildung werden also auf der Oberfläche der Leiterplatte Lötstoppschichten unterschiedlicher Lötstoppschicht-Dicke sowie gegebenenfalls verschiedenartige Lötstoppschichten (d.h. Lötstopplack und Folie) eingesetzt. Dies ermöglicht es, z.B. die an die Lötkontakte eines Bauelements angrenzende Lötstoppschicht auf das spezielle Bauelement abzustimmen. Dadurch kann zum Beispiel ein lokal hoher Isolationswiderstand für die eingangs erwähnten HF-Bauelemente über die Lötstoppschicht-Dicke eingestellt werden.

Bei dem abgedeckten Bauelement handelt es sich bevorzugt um ein verhältnismäßig kleines Bauelement. In einer bevorzugten Ausgestaltung weist daher das durch die erste Folie abgedeckte Bauelement oder zumindest eines der durch die erste Folie abgedeckten Bauelemente in einer zu der Oberfläche der Leiterplatte im Wesentlichen parallelen Richtung oder in zwei zu der Oberfläche der Leiterplatte im Wesentlichen parallelen Richtungen eine Bauelement-Kantenlänge auf, die kleiner als 5mm ist. Insbesondere ist die Bauelement-Kantenlänge kleiner als 1mm und vorzugsweise kleiner als 0,5mm. In einer zu der Oberfläche der Leiterplatte im Wesentlichen senkrechten Richtung weist das Bauelement eine Bauelement-Höhe auf, die kleiner als 1mm ist. Insbesondere ist die Bauelement-Höhe kleiner als 0,5 mm und vorzugsweise kleiner als 0,3 mm.

In einer Ausgestaltung ist/sind das oder die durch die erste Folie abgedeckte/n Bauelement/e SMD-gelötet. Alternativ ist es z.B. möglich, das oder die durch die Folie abgedeckte/n Bauelemente/n mittels Leitkleber auf der Oberfläche der Leiterplatte zu befestigen.

In einer besonders vorteilhaften Weiterbildung ist eines der unbedeckten Bauelemente derart auf der dem abgedeckten Bauelement abgewandten Seite der ersten Folie angeordnet ist, dass sich in der zu der Oberfläche der Leiterplatte im Wesentlichen senkrechten Richtung die folgende Anordnung ergibt: Leiterplatte, abgedecktes Bauelement, erste Folie, unbedecktes Bauelement. Als "Seite der Folie" ist hierbei jeweils derjenige Bereich bezeichnet, welcher sind in Richtung der Oberflächennormale auf einer der beiden Oberflächen der Folie erstreckt. In dieser Weiterbildung sind das abgedeckte und das unbedeckte Bauelement in Bezug zu der zu der Oberfläche im Wesentlichen senkrechten Richtung direkt übereinander angeordnet. Dadurch lässt sich derjenige Platz, welcher durch das Abdecken des abgedeckten Bauelements geschaffen wird, von dem direkt darüber angeordneten, unbedeckten Bauelement optimal nutzen.

In einer bevorzugten Ausgestaltung dieser Weiterbildung weist das unbedeckte Bauelement ein optisches Empfangselement und das abgedeckte Bauelement ein optisches Sendeelement auf. Alternativ weist das unbedeckte Bauelement ein optisches Sendeelement und das abgedeckte Bauelement ein optisches Empfangselement auf. Die Anordnung bzw. Ausgestaltung von Sende- und Empfangselement ist derart, dass das Sendeelement optische elektromagnetische Wellen in Richtung des Empfangselements aussendet und dass das Empfangselement aus Richtung des Sendeelements kommende optische elektromagnetische Wellen empfängt. Das abgedeckte Bauelement, die erste Folie und das unbedeckte Bauelement bilden einen der galvanischen Trennung dienenden Optokoppler. Aus dem Stand der Technik bekannte Optokoppler finden entweder als ein diskretes Bauelement mit einem relativ hohem Platzbedarf Anwendung, oder können als zwei separate Bauelementen mit einem relativ hohem Platzbedarf ausgebildet werden. Daher wird für den Fall, dass eine galvanische Trennung erforderlich ist, in dieser Ausgestaltung der Platzbedarf weiterhin erheblich reduziert. Eine derartige galvanische Trennung wird oftmals auch in den eingangs erwähnten Maßnahmen zum Explosionsschutz gefordert.

Bezüglich des Verfahrens wird die Aufgabe gelöst durch ein Verfahren zur Herstellung einer erfindungsgemäßen Leiterplatte, das zumindest folgende Verfahrensschritte umfasst: Vorfertigung der unbestückten Leiterplatte und gegebenenfalls Einbringen von Kavitäten; Anordnen, insbesondere SMD-Auflöten, des zumindest einen abzudeckenden Bauelements auf der Oberfläche der Leiterplatte; Nachfolgendes Aufbringen der als Lötstoppschicht dienenden ersten Folie auf zumindest einem erstem Anteil, vorzugsweise einem Großteil der isolierenden Bereiche, wobei das zumindest eine abzudeckende Bauelement durch die erste Folie zumindest teilweise, insbesondere vollständig, abgedeckt wird; und Anordnung und Auflöten von unbedeckten SMD- und/oder THT-Bauelementen auf der Oberfläche der Leiterplatte, wobei die erste Folie als Lötstoppschicht bei dem Auflöten der SMD- und/oder THT-Bauelemente dient.

Die Verfahrensschritte der Vorfertigung der Leiterplatte, des Anordnens, insbesondere SMD-Auflöten, des zumindest einen abzudeckenden Bauelements und des nachfolgenden Aufbringens der als Lötstoppschicht dienenden ersten Folie können dabei bevorzugt beim Hersteller der Leiterplatte vorgenommen werden. Anschließen werden im Zuge der Weiterverarbeitung der Leiterplatte, beispielsweise bei einem Hersteller von Feldgeräten, in welchen die Leiterplatte zum Einsatz kommen, die unbedeckten SMD- und/oder THT-Bauelemente auf der Oberfläche angeordnet und aufgelötet. Die erste Folie dient dabei als Lötstoppschicht bei dem Auflöten der Bauelemente. Beispielsweise handelt es sich bei den abgedeckten Bauelementen um standardisierte Bauelemente, die z.B. in einer Vielzahl von unterschiedlichen Feldgeräten zum Einsatz kommen. Dadurch wird ein hoher Modularisierungsgrad in der gesamten Fertigungskette erreicht.

Gegebenenfalls kann auch für das Auflöten des abzudeckenden Bauelements eine Lötstoppschicht erforderlich sein, welche zwischen den Lötkontakten des abzudeckenden Bauelements angeordnet ist. In einer Ausgestaltung des Verfahrens wird daher vor dem Anordnen, insbesondere vor dem Auflöten, des zumindest einen abzudeckenden Bauelements auf der Oberfläche der Leiterplatte eine Lötstoppschicht zwischen den Lötkontakten des abzudeckenden Bauelementes, insbesondere eine als Lötstopplack oder Folie ausgebildete Lötstoppschicht, aufgebracht.

In einer weiteren Ausgestaltung des Verfahrens wird vor dem Anordnen und Auflöten der unbedeckten Bauelemente auf einem zweiten Anteil der isolierenden Bereiche der als Lötstoppschicht dienende Lötstopplack aufgebracht und/oder auf einem dritten Anteil der isolierenden Bereiche wird die als Lötstoppschicht dienende zweite Folie aufgebracht. Die Erfindung wird anhand der nachfolgenden, nicht maßstabsgetreuen Figuren näher erläutert, wobei gleiche Bezugszeichen gleiche Merkmale bezeichnen. Wenn es die Übersichtlichkeit erfordert oder es anderweitig sinnvoll erscheint, wird auf bereits erwähnte Bezugszeichen in nachfolgenden Figuren verzichtet. Es zeigt:
Fig. 1: Eine Schnittansicht einer Ausgestaltung einer erfindungsgemäßen Leiterplatte;
Fig. 2: Eine Schnittansicht einer weiteren Ausgestaltung einer erfindungsgemäßen Leiterplatte;
Fig. 3: Eine Aufsicht auf eine Ausgestaltung einer erfindungsgemäßen Leiterplatte.

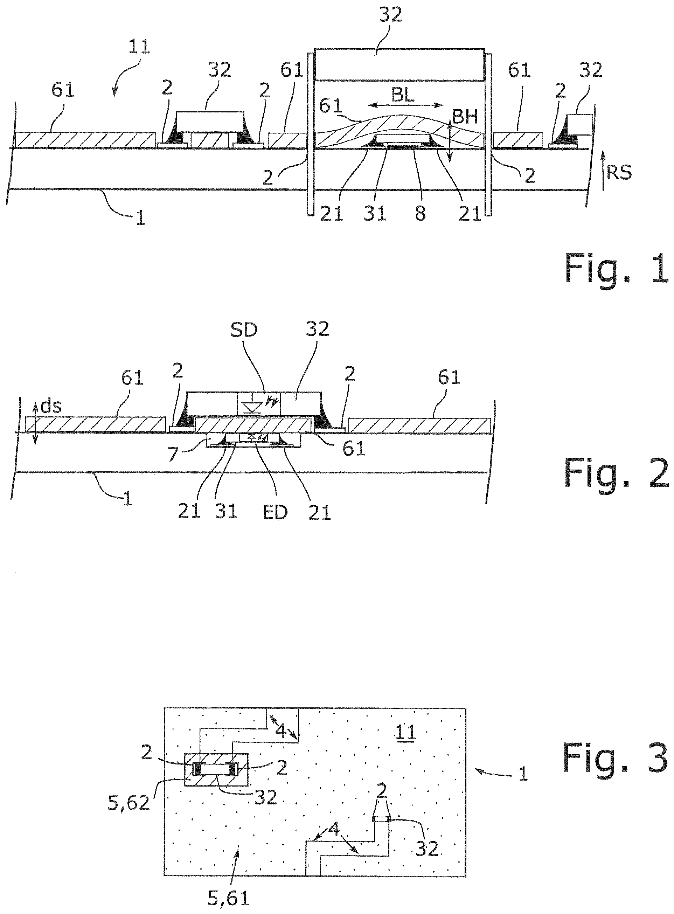

In Fig. 1 ist eine Schnittansicht eines Ausschnitts einer Ausgestaltung einer erfindungsgemäßen Leiterplatte 1 dargestellt, wobei auf einer Oberfläche 11 der Leiterplatte 1 vier Bauelemente 31,32,... auf ihre jeweiligen Lötkontakte 21,2, ... aufgelötet sind. Dabei handelt es sich um drei SMD-Bauelemente 31,32,... und ein THT-Bauelement 32. Die erste Folie 61 ist dabei auf einem Großteil der isolierenden Bereiche (hier nicht gezeigtdient als eine Lötstoppschicht zum Auflöten der unbedeckten Bauelemente 32. Als erste Folie 61 eignet sich z.B. die von unter dem Handelsnamen Vacrel^{®} in unterschiedlichen Schichtdicken von ca. 50-150 Mikrometer vertriebene Folie.

Erfindungsgemäß ist auf der Oberfläche 11 der Leiterplatte 1 zumindest ein durch die erste Folie 61 abgedecktes Bauelement 31 angeordnet. Das abgedeckte Bauelement 31 ist wird dabei vor dem Aufbringen der ersten Folie 61 auf der Oberfläche 11 der Leiterplatte 1 angeordnet und befestigt. Dies geschieht bevorzugt bei dem Leiterplattenhersteller, welcher die erste Folie 61 im Rahmen des Herstellungsprozesses der Leiterplatte 1 aufbringt. In diesem Ausführungsbeispiel handelt es sich bei dem abgedeckten Bauelement 31 um ein SMD-gelötetes Bauelement 31.

Zwischen den Lötkontakten 21 des ersten Bauelements 31 ist ferner lokal eine Lötstoppschicht aufgebracht, hier ein Lötstopplack 8, je nach Art den Bauelement und/oder Ausgestaltung der Lötkontakte 21 kann diese Lötstoppschicht gegebenenfalls auch weggelassen werden. Selbstverständlich kann das abgedeckte Bauelement 31 auch z.B. mit Leiterplattenkleber auf die Oberfläche 11 der Leiterplatte 1 geklebt sein. Das abgedeckte Bauelement 31 ist ein Chip des Baugröße Codes 0201 nach dem EIA-Standard, und hat damit eine Bauelement-Kantenlängen BL von 0,6 bzw. 0,3 mm. Die Bauelement-Höhe BH beträgt 0,5 mm.

Bei dem unbedeckten Bauelement 32 handelt es sich hier um ein THT-Bauelement. Dadurch, dass das abgedeckte Bauelement 31 durch die erste Folie 61 abgedeckt ist, ermöglicht dies, das unbedeckte Bauelement 32 unmittelbar oberhalb des abgedeckten Bauelements 31 d.h auf der dem abgedeckten Bauelement 31 abgewandten Seite der ersten Folie 61 anzuordnen, in Bezug zur der zu der Oberfläche 11 der Leiterplatte im Wesentlichen senkrechten Richtung RS. Die hier dargestellte leichte Wölbung der ersten Folie 61 ist dabei nicht als kritisch in Bezug zu bewerten, solange sichergestellt ist, dass die Anhaftungseigenschaften der ersten Folie 61 auf der Oberfläche 11 der Leiterplatte 1 noch als hinreichend gut sind; dies kann beispielsweise durch experimentelle Untersuchungen bewertet werden.

In Fig. 2 ist eine Schnittansicht eines Ausschnitts einer weiteren Ausgestaltung einer erfindungsgemäßen Leiterplatte 1 dargestellt, wobei hier nur das abgedeckte Bauelement 31 und ein unmittelbar oberhalb des abgedeckten Bauelements 31 angeordnetes unbedecktes Bauelement 32 gezeigt ist. Bei beiden Bauelementen 31,32 sind SMD-gelötet. Das abgedeckte Bauelement ist hierbei im Wesentlichen vollständig in einer Kavität 7 angeordnet; das Merkmal der Kavität 7 kann selbstverständlich auch dem in Fig. 1 gezeigten Ausführungsbeispiel hinzugefügt werden. Anhand der Kavität 7 wird eine im Wesentlichen ebene Ausrichtung der ersten Folie ermöglicht, welche hier eine Schichtdicke ds von 120 Mikrometer aufweist.

In dieser bevorzugten Ausgestaltung weist zusätzlich das abgedeckte Bauelement 31 eine Empfangsdiode auf, die als Empfangselement ED für optische elektromagnetische Wellen dient. Das unbedeckte Bauelement 32 weist eine Sendediode auf, die als Sendeelement SD für optische elektromagnetische Wellen dient d.h. das Sende- SD bzw. Empfangselement ED sind zum Senden bzw. zum Empfang optischer elektromagnetischer Wellen ausgestaltet. Bei der Diode als Sendeelement SD handelt es sich um eine Leuchtdiode und bei der Diode als Empfangselements ED und eine Fotodiode. Die Anordnung der Dioden ist derart, dass das Sendeelement SD optische elektromagnetische Wellen in Richtung des Empfangselements ED aussendet und dass das Empfangselement ED aus Richtung des Sendeelements SD kommende optische elektromagnetische Wellen empfängt. Die erste Folie 61 ist gerade für optische elektromagnetische Wellen aus demjenigen Frequenzbereich durchlässig, in welchem die von der Leuchtdiode ausgesendeten optischen elektromagnetischen Wellen liegen. In dieser Ausgestaltung bilden das Sendelement SD, das Empfangselement ED, sowie die erste Folie 61 einen der galvanischen Trennung dienenden Optokoppler.

In Fig. 3 ist eine Aufsicht auf einen Ausschnitt einer Ausgestaltung einer erfindungsgemäßen Leiterplatte gezeigt, wobei hier das durch die erste Folie 61 vollständig abgedeckte Bauelement 31 nicht sichtbar ist. Auf einem Großteil der isolierenden Bereiche 5 ist die als Lötstoppschicht dienende erste Folie 61 aufgebracht. Für eines der beiden unbedeckten Bauelemente 32,.. ist eine weitere Lötstoppschicht vorgesehen welche an die Lötkontakte 22 des unbedeckten Bauelements 32 angrenzt. Bei der Lötstoppschicht handelt es sich hier um eine zweite Folie 62, deren Lötstoppschicht-Dicke größer als die Lötstoppschicht-Dicke ds der ersten Folie 61 ist. Für das zweite unbedeckte Bauelement 32 bzw. dessen Lötkontakte 22 wird die das abgedeckte Bauelement 31 abdeckende erste Folie 61 als Lötstoppschicht verwendet. Dadurch werden in diesem Ausführungsbeispiel zumindest zwei Folien 61, 62 verschiedener Schichtdicken verwendet, gegebenenfalls kann aber auch zusätzlich oder alternativ ein Lötstopplack eingesetzt werden.

### Bezugszeichen und Symbole

- 1: Leiterplatte
- 11: Oberfläche der Leiterplatte
- 2: Lötkontakte
- 21: .Lötkontakte des abgedeckten Bauelemen
- 31,32: Bauelemente
- 31: abgedecktes Bauelement
- 32: unbedecktes Bauelement
- 4: Leiterbahnen
- 5: isolierende Bereiche
- 61: erste Folie
- 62: zweite Folie
- 7: Kavität
- 8: Lötstopplack
- ds: Schichtdicke der ersten Folie
- RS: senkrechte Richtung
- BL: Bauelement-Kantenlänge
- BH: Bauelement-Höhe
- SD: Sendeelement
- ED: Empfangselement

## Patentansprüche

1. Leiterplatte (1), wobei auf zumindest einer Oberfläche (11) der Leiterplatte (1) Lötkontakte (2) mit darauf aufgelöteten Bauelementen (31,32,..), Leiterbahnen (4) sowie die Lötkontakte (2) und/oder die Leiterbahnen (4) gegeneinander isolierende Bereiche (5) vorgesehen sind,
wobei auf zumindest einem Großteil der isolierenden Bereiche (5), eine als Lötstoppschicht dienende erste Folie (61) aufgebracht ist,
und wobei zumindest eines der Bauelemente (31) in einer zu der Oberfläche (11) der Leiterplatte (1) im Wesentlichen senkrechten Richtung (RS) zwischen der Leiterplatte (1) und der ersten Folie (61) angeordnet ist und zumindest teilweise, insbesondere vollständig, durch die erste Folie (61) abgedeckt ist, wobei die Leiterplatte mindestens ein unbedecktes Bauelement (32) aufweist, an deren Lötkontakte (2) die als Lötstoppschicht dienende erste Folie (61) angrenzt, wobei die erste Folie (61) zwischen dem unbedeckten Bauelement (32) und der Leiterplatte (1) angeordnet ist., und wobei die Folie eine Stärke von 50µm bis 150 µm aufweist.

2. Leiterplatte (1) nach Anspruch 1,
wobei das durch die erste Folie (61) abgedeckte Bauelement (31) oder zumindest eines der durch die erste Folie (61) abgedeckten Bauelemente (31;...) in einer in der Leiterplatte (1) eingebrachten Kavität (7) angeordnet ist.

3. Leiterplatte (1) nach zumindest einem der vorherigen Ansprüche,
wobei die Kavität (7) derart bemessen ist, dass das durch die erste Folie (61) abgedeckte Bauelement (31) im Wesentlichen vollständig innerhalb der Kavität (7) angeordnet ist .

4. Leiterplatte (1) nach zumindest einem der vorherigen Ansprüche,
wobei auf einem zweiten Anteil der isolierenden Bereiche (5) ein als Lötstoppschicht dienender Lötstopplack (8) aufgebracht ist,
und/oder
wobei auf einem drittem Anteil der isolierenden Bereiche (5) eine als Lötstoppschicht dienende zweite Folie (62) aufgebracht ist,
und wobei der Lötstopplack (8) und/oder die zweite Folie (62) eine Lötstoppschicht-Dicke aufweisen, die von der Lötstoppschicht-Dicke (ds) der das zumindest eine Bauelement (31) abdeckenden ersten Folie (61) verschieden ist.

5. Leiterplatte (1) nach zumindest einem der vorherigen Ansprüche,
wobei das durch die erste Folie (61) abgedeckte Bauelement (31) oder zumindest eines der durch die erste Folie (61) abgedeckten Bauelemente (31;..)
- in zumindest einer zu der Oberfläche (11) der Leiterplatte (1) im Wesentlichen parallelen Richtung eine Bauelement-Kantenlänge aufweist (BL), die kleiner als 5mm, insbesondere kleiner als 1mm und vorzugsweise kleiner als 0,7mm ist; und
- in einer zu der Oberfläche (11) der Leiterplatte (1) im Wesentlichen senkrechten Richtung (RS) eine Bauelement-Höhe (BH) aufweist, die kleiner als 1mm, insbesondere kleiner als 0,5 mm und vorzugsweise kleiner als 0,3 mm ist.

6. Leiterplatte (1) nach zumindest einem der vorherigen Ansprüche,
wobei das/die durch die erste Folie (61) abgedeckte/n Bauelement/e (31;...) SMD-gelötet ist/sind.

7. Leiterplatte (1) nach zumindest einem der vorherigen Ansprüche,
wobei eines der unbedeckten Bauelemente (32) derart auf der dem abgedeckten Bauelement (31) abgewandten Seite der ersten Folie (61) angeordnet ist, dass sich in der zu der Oberfläche (11) der Leiterplatte (1) im Wesentlichen senkrechten Richtung (RS) die folgende Anordnung ergibt:
- Leiterplatte (1), abgedecktes Bauelement (31), erste Folie (61), unbedecktes Bauelement (32).

8. Leiterplatte (1) nach zumindest einem der vorherigen Ansprüche,
wobei das unbedeckte Bauelement (32) ein optisches Empfangselement (ED) und das abgedeckte Bauelement (31) ein optisches Sendeelement (SD) aufweist,
oder
wobei das unbedeckte Bauelement (32) ein optisches Sendeelement (SD) und das abgedeckte Bauelement (31) ein optisches Empfangselement (ED) aufweist,
wobei die Anordnung von Sende- (SD) und Empfangselement (ED) derart ist,
- dass das Sendeelement (SD) optische elektromagnetische Wellen in Richtung des Empfangselements (ED) aussendet und
- dass das Empfangselement (ED) aus Richtung des Sendeelements (SD) kommende optische elektromagnetische Wellen empfängt,
und wobei das abgedeckte Bauelement (31), die erste Folie (61) und das unbedeckte Bauelement (32) einen der galvanischen Trennung dienenden Optokoppler bilden.

9. Verfahren zur Herstellung einer Leiterplatte (1) nach zumindest einem der Ansprüche 1 bis 8,
wobei das Verfahren zumindest folgende Verfahrensschritte umfasst,
- Vorfertigung der unbestückten Leiterplatte (1) und gegebenenfalls Einbringen von Kavitäten;
- Anordnen, insbesondere SMD-Auflöten, des zumindest einen abzudeckenden Bauelements (31) auf der Oberfläche (11) der Leiterplatte (1);
- Nachfolgendes Aufbringen der als Lötstoppschicht dienenden ersten Folie (61) auf zumindest einem erstem Anteil, vorzugsweise einem Großteil der isolierenden Bereiche (5), wobei das zumindest eine abzudeckende Bauelement (31) durch die erste Folie (61) zumindest teilweise, insbesondere vollständig, abgedeckt wird; und
- Anordnung und Auflöten von unbedeckten SMD- und/oder THT-Bauelementen (32, ...) auf der Oberfläche (11) der Leiterplatte (1), wobei die erste Folie (61) als Lötstoppschicht bei dem Auflöten dient, wobei die erste Folie (61) zwischen dem unbedeckten Bauelement (32) und der Leiterplatte (1) angeordnet ist., und wobei die Folie eine Stärke von 50µm bis 150 µm aufweist.

10. Verfahren nach Anspruch 9,
wobei vor dem Anordnen, insbesondere vor dem Auflöten, des zumindest einen abzudeckenden Bauelements (31) auf der Oberfläche (11) der Leiterplatte (1) eine Lötstoppschicht zwischen den Lötkontakten (21) des abzudeckenden Bauelementes (31), insbesondere eine als Lötstopplack oder Folie ausgebildete Lötstoppschicht, aufgebracht wird.

11. Verfahren nach zumindest einem der Ansprüche 9 oder 10 ,
wobei vor dem Anordnen und Auflöten der unbedeckten Bauelemente (32,...)
- auf einem zweiten Anteil der isolierenden Bereiche (5) der als Lötstoppschicht dienende Lötstopplack (8) aufgebracht wird und/oder
- auf einem dritten Anteil der isolierenden Bereiche (5) die als Lötstoppschicht dienende zweite Folie (62) aufgebracht wird.

## Claims

1. printed circuit board (1), wherein solder contacts (2) with components (31, 32,..) soldered thereon, conductor tracks (4) and regions (5) insulating the solder contacts (2) and/or the conductor tracks (4) from one another are provided on at least one surface (11) of the printed circuit board (1),
wherein a first foil (61) serving as a solder resist layer is applied to at least a majority of the insulating regions (5),
and wherein at least one of the components (31) is arranged between the printed circuit board (1) and the first foil (61) in a direction (RS) substantially perpendicular to the surface (11) of the printed circuit board (1) and is at least partially, in particular completely, covered by the first foil (61), the printed circuit board having at least one uncovered component (32) whose solder contacts (2) are adjoined by the first foil (61) serving as a solder-stop layer, the first foil (61) being arranged between the uncovered component (32) and the printed circuit board (1), and the foil having a thickness of 50 µm to 150 µm.

2. printed circuit board (1) according to claim 1,
wherein the component (31) covered by the first foil (61) or at least one of the components (31;...) covered by the first foil (61) is arranged in a cavity (7) provided in the printed circuit board (1).

3. printed circuit board (1) according to at least one of the preceding claims,
wherein the cavity (7) is dimensioned such that the component (31) covered by the first foil (61) is arranged substantially completely within the cavity (7).

4. printed circuit board (1) according to at least one of the preceding claims,
wherein a solder resist (8) serving as a solder resist layer is applied to a second portion of the insulating regions (5),
and/or
wherein a second foil (62) serving as a solder resist layer is applied to a third portion of the insulating regions (5),
and wherein the solder resist (8) and/or the second foil (62) have a solder resist layer thickness which is different from the solder resist layer thickness (ds) of the first foil (61) covering the at least one component (31).

5. printed circuit board (1) according to at least one of the preceding claims,
wherein the component (31) covered by the first film (61) or at least one of the components (31;..) covered by the first film (61)
- has, in at least one direction substantially parallel to the surface (11) of the printed circuit board (1), a component edge length (BL) which is less than 5 mm, in particular less than 1 mm and preferably less than 0.7 mm; and
- in a direction (RS) substantially perpendicular to the surface (11) of the printed circuit board (1) has a component height (BH) which is less than 1 mm, in particular less than 0.5 mm and preferably less than 0.3 mm.

6. printed circuit board (1) according to at least one of the preceding claims,
wherein the component(s) (31;...) covered by the first foil (61) is/are SMD-soldered.

7. printed circuit board (1) according to at least one of the preceding claims,
wherein one of the uncovered components (32) is arranged on the side of the first foil (61) facing away from the covered component (31) in such a way that the following arrangement results in the direction (RS) substantially perpendicular to the surface (11) of the printed circuit board (1):
- Printed circuit board (1), covered component (31), first foil (61), uncovered component (32).

8. printed circuit board (1) according to at least one of the preceding claims,
wherein the uncovered component (32) has an optical receiving element (ED) and the covered component (31) has an optical transmitting element (SD),
or
wherein the uncovered component (32) has an optical transmitting element (SD) and the covered component (31) has an optical receiving element (ED),
the arrangement of the transmitting (SD) and receiving (ED) elements being such,
- that the transmitting element (SD) transmits optical electromagnetic waves in the direction of the receiving element (ED) and
- that the receiving element (ED) receives optical electromagnetic waves coming from the direction of the transmitting element (SD),
and wherein the covered component (31), the first foil (61) and the uncovered component (32) form an optocoupler serving for galvanic isolation.

9. method for manufacturing a printed circuit board (1) according to at least one of claims 1 to 8,
wherein the method comprises at least the following method steps,
- Prefabrication of the unassembled PCB (1) and insertion of cavities if necessary;
- Arrangement, in particular SMD soldering, of the at least one component (31) to be covered on the surface (11) of the printed circuit board (1);
- Subsequent application of the first foil (61) serving as a solder resist layer to at least a first portion, preferably a majority, of the insulating regions (5), the at least one component (31) to be covered being at least partially, in particular completely, covered by the first foil (61); and
- Arrangement and soldering of uncovered SMD and/or THT components (32, ...) on the surface (11) of the printed circuit board (1), wherein the first foil (61) serves as a solder resist layer during the soldering, wherein the first foil (61) is arranged between the uncovered component (32) and the printed circuit board (1), and wherein the foil has a thickness of 50 µm to 150 µm.

10. method according to claim 9,
wherein a solder resist layer is applied between the solder contacts (21) of the component (31) to be covered, in particular a solder resist layer formed as solder resist lacquer or foil, before the arrangement, in particular before the soldering, of the at least one component (31) to be covered on the surface (11) of the printed circuit board (1).

11. method according to at least one of claims 9 or 10,
whereby before arranging and soldering the uncovered components (32,...)
- the solder resist (8) serving as a solder resist layer is applied to a second portion of the insulating regions (5) and/or
- the second foil (62), which serves as a solder resist layer, is applied to a third portion of the insulating areas (5).

## Revendications

1. plaquette (1) à circuit imprimé, dans laquelle il est prévu sur au moins une surface (11) de la plaquette (1) à circuit imprimé des contacts (2) à souder sur lesquels sont soudés des composants (31, 32,..), des pistes (4) conductrices ainsi que des zones (5) isolant les contacts (2) à souder et/ou les pistes (4) conductrices les uns des autres,
dans lequel une première feuille (61) servant de couche d'arrêt de soudure est appliquée sur au moins une grande partie des zones isolantes (5),
et au moins l'un des composants (31) étant disposé dans une direction (RS) essentiellement perpendiculaire à la surface (11) de la carte de circuit imprimé (1) entre la carte de circuit imprimé (1) et la première feuille (61) et étant recouvert au moins partiellement, en particulier complètement, par la première feuille (61), la carte à circuits imprimés présentant au moins un composant (32) non recouvert, aux contacts de soudage (2) duquel est adjacente la première feuille (61) servant de couche d'arrêt de soudage, la première feuille (61) étant disposée entre le composant (32) non recouvert et la carte à circuits imprimés (1), et la feuille présentant une épaisseur de 50 µm à 150 µm.

2. carte de circuit imprimé (1) selon la revendication 1,
le composant (31) recouvert par la première feuille (61) ou au moins l'un des composants (31 ; ...) recouverts par la première feuille (61) étant disposé dans une cavité (7) ménagée dans la carte de circuit imprimé (1).

3. Carte de circuit imprimé (1) selon au moins l'une des revendications précédentes,
la cavité (7) étant dimensionnée de telle sorte que le composant (31) recouvert par la première feuille (61) est disposé sensiblement entièrement à l'intérieur de la cavité (7).

4. Carte de circuit imprimé (1) selon au moins l'une des revendications précédentes,
un vernis d'arrêt de brasage (8) servant de couche d'arrêt de brasage étant appliqué sur une deuxième partie des zones isolantes (5),
et/ou
une deuxième feuille (62) servant de couche d'arrêt de brasage étant appliquée sur une troisième partie des zones isolantes (5),
et dans lequel le vernis d'arrêt de soudure (8) et/ou la deuxième feuille (62) présentent une épaisseur de couche d'arrêt de soudure qui est différente de l'épaisseur de couche d'arrêt de soudure (ds) de la première feuille (61) recouvrant le au moins un composant (31).

5. Carte de circuit imprimé (1) selon au moins l'une des revendications précédentes,
dans lequel le composant (31) recouvert par la première feuille (61) ou au moins l'un des composants (31 ;...) recouverts par la première feuille (61)
- présente, dans au moins une direction sensiblement parallèle à la surface (11) de la carte de circuit imprimé (1), une longueur de bord de composant (BL) qui est inférieure à 5 mm, en particulier inférieure à 1 mm et de préférence inférieure à 0,7 mm ; et
- présente, dans une direction (RS) sensiblement perpendiculaire à la surface (11) de la carte de circuit imprimé (1), une hauteur de composant (BH) qui est inférieure à 1 mm, en particulier inférieure à 0,5 mm et de préférence inférieure à 0,3 mm.

6. Carte de circuit imprimé (1) selon au moins l'une des revendications précédentes, le(s) composant(s) (31 ;...) recouvert(s) par la première feuille (61) étant soudé(s) en CMS.

7. Carte de circuit imprimé (1) selon au moins l'une des revendications précédentes,
l'un des composants (32) non recouverts étant disposé sur la face de la première feuille (61) opposée au composant (31) recouvert de telle sorte que l'on obtienne la disposition suivante dans la direction (RS) essentiellement perpendiculaire à la surface (11) de la carte de circuit imprimé (1) :
- Carte de circuit imprimé (1), composant recouvert (31), première feuille (61), composant non recouvert (32).

8. Carte de circuit imprimé (1) selon au moins l'une des revendications précédentes,
dans lequel le composant non recouvert (32) comprend un élément de réception optique (ED) et le composant recouvert (31) comprend un élément d'émission optique (SD),
ou
dans lequel le composant non recouvert (32) comprend un élément d'émission optique (SD) et le composant recouvert (31) comprend un élément de réception optique (ED), l'agencement des éléments d'émission (SD) et de réception (ED) étant tel,
- en ce que l'élément d'émission (SD) émet des ondes électromagnétiques optiques en direction de l'élément de réception (ED) et
- en ce que l'élément de réception (ED) reçoit des ondes électromagnétiques optiques venant de la direction de l'élément d'émission (SD),
et dans lequel le composant recouvert (31), la première feuille (61) et le composant non recouvert (32) forment un optocoupleur servant à l'isolation galvanique.

9. Procédé de fabrication d'un circuit imprimé (1) selon au moins l'une des revendications 1 à 8,
le procédé comprenant au moins les étapes de procédé suivantes,
- Préfabrication du circuit imprimé non équipé (1) et, le cas échéant, mise en place des cavités ;
- disposer, en particulier par brasage SMD, le au moins un composant (31) à recouvrir sur la surface (11) de la carte de circuit imprimé (1) ;
- l'application ultérieure de la première feuille (61) servant de couche d'arrêt de brasage sur au moins une première partie, de préférence une grande partie des zones isolantes (5), le au moins un composant (31) à recouvrir étant recouvert au moins partiellement, en particulier complètement, par la première feuille (61) ; et
- Disposition et soudage de composants SMD et/ou THT non recouverts (32, ...) sur la surface (11) de la carte de circuit imprimé (1), la première feuille (61) servant de couche d'arrêt de soudure lors du soudage, la première feuille (61) étant disposée entre le composant non recouvert (32) et la carte de circuit imprimé (1), et la feuille présentant une épaisseur de 50 µm à 150 µm.

10. Procédé selon la revendication 9,
dans lequel, avant l'agencement, en particulier avant le brasage, du au moins un composant (31) à recouvrir sur la surface (11) de la carte à circuits imprimés (1), une couche d'arrêt de brasage est appliquée entre les contacts de brasage (21) du composant (31) à recouvrir, en particulier une couche d'arrêt de brasage réalisée sous forme de vernis d'arrêt de brasage ou de film.

11. Procédé selon au moins l'une des revendications 9 ou 10 ,
dans lequel, avant la mise en place et le soudage des composants non recouverts (32, ...)
- le vernis d'arrêt de brasage (8) servant de couche d'arrêt de brasage est appliqué sur une deuxième partie des zones isolantes (5) et/ou
- la deuxième feuille (62) servant de couche d'arrêt de brasage est appliquée sur une troisième partie des zones isolantes (5).
